# FASCICULE DE BREVET EUROPEEN

(11) **EP 2 920 125 B1**
(45) Date de publication et mention de la délivrance du brevet: **25.09.2019**
(21) Numéro de dépôt: 13803132.3
(22) Date de dépôt: 13.11.2013
(51) Int. Cl.: C03C 10/00, F21V 1/02, F21V 3/04, H01L 33/50

(54) **ARTICLE VITROCERAMIQUE A AFFICHAGE LUMINEUX**
GLASKERAMIK MIT EINER LICHTEMITTIERENDEN ANZEIGE
GLASS CERAMIC WITH A LIGHT-EMITTING DISPLAY

(30) Priorité: 14.11.2012 FR 1260827
(43) Date de publication de la demande: 23.09.2015
(73) Titulaire: Eurokera S.N.C., 02400 Château-Thierry (FR)
(72) Inventeur: LALUET, Jean-Yves, F-75019 Paris (FR); GUISET, Pierrick, F-91300 Massy (FR); VILATO, Pablo, F-75014 Paris (FR); MALLET, Claire, Outremont, QC H2V 1V7 (CA)
(74) Mandataire: Saint-Gobain Recherche
(86) Numéro de dépôt international: PCT/FR2013/052719
(87) Numéro de publication internationale: WO 2014/076411

(56) Documents cités:
- WO-A1-2011/089327
- WO-A1-2012/001300
- DE-A1-102010 061 123

## Description

La présente invention concerne le domaine des vitrocéramiques. Plus précisément, elle concerne un article (ou produit) en vitrocéramique, notamment une plaque vitrocéramique, destiné(e) en particulier à couvrir ou recevoir des éléments de chauffage, ledit article étant pourvu d'un affichage lumineux coloré (ou d'au moins une zone lumineuse colorée) en au moins une zone choisie de l'article.

Les ventes d'articles tels que des plaques de cuisson en vitrocéramique sont en augmentation constante depuis plusieurs années. Ce succès s'explique notamment par l'aspect attractif de ces plaques et par leur facilité de nettoyage.

Rappelons qu'une vitrocéramique est à l'origine un verre, dit verre précurseur (ou verre-mère ou green-glass), dont la composition chimique spécifique permet de provoquer par des traitements thermiques adaptés, dits de céramisation, une cristallisation contrôlée. Cette structure spécifique en partie cristallisée confère à la vitrocéramique des propriétés uniques.

Il existe actuellement différents types de plaques en vitrocéramique, chaque variante étant le résultat d'études importantes et de nombreux essais, étant donné qu'il est très délicat de faire des modifications sur ces plaques et/ou sur leur procédé d'obtention sans risquer un effet défavorable sur les propriétés recherchées : pour pouvoir être utilisée comme plaque de cuisson, une plaque vitrocéramique doit généralement présenter une transmission dans les longueurs d'onde du domaine du visible à la fois suffisamment basse pour masquer au moins une partie des éléments de chauffage sous-jacents au repos et suffisamment élevée pour que, selon les cas (chauffage radiant, chauffage par induction, etc), l'utilisateur puisse détecter visuellement les éléments de chauffage en état de marche dans un but de sécurité ; elle doit également présenter une transmission élevée dans les longueurs d'onde du domaine de l'infrarouge dans le cas notamment des plaques à foyers radiants.

Les principales plaques actuelles sont de couleur sombre, en particulier noires, colorées par exemple en utilisant de l'oxyde de vanadium ajouté aux matières premières du verre-mère avant la fusion, cet oxyde conférant après céramisation une teinte orange-brune soutenue liée à une réduction du vanadium. D'autres colorants, tels que les oxydes de cobalt et de manganèse, peuvent également être utilisés. Avec un coefficient de transmission faible en dessous de 600nm, ces plaques permettent surtout la visibilité d'éléments rouges comme les éléments chauffants portés à haute température ou encore les affichages lumineux à base de diodes électroluminescentes monochromatiques de couleur rouge. Des plaques vitrocéramiques plus transparentes (telles que les vitrocéramiques KeraVision ou KeraResin, commercialisées par la société EuroKera), existent également, permettant l'affichage d'autres couleurs "pures" (produites par des diodes monochromatiques), telles que le bleu ou le vert.

Il est cependant apparu récemment un besoin de pouvoir visualiser une variété plus importante d'affichages avec des couleurs plus variées, faisant appel en particulier à des couleurs de synthèse produites par des mélanges à plusieurs longueurs d'onde (cas de la couleur blanche). Le coefficient de transmission des plaques vitrocéramiques n'étant pas uniforme sur l'ensemble du spectre visible, les amplitudes relatives des différentes composantes (spectrales) de la lumière transmise sont cependant généralement modifiées, la couleur après transmission pouvant dévier fortement de celle produite par la source.

En particulier, les technologies à base de diodes électroluminescentes (LEDs) habituellement employées pour produire une lumière blanche (par exemple avec une source de lumière bleue recouverte d'un élément absorbant une partie de ladite lumière et réémettant de la lumière jaune) ne peuvent pas être utilisées pour produire une couleur blanche à travers une vitrocéramique. Alors que la balance entre le bleu et le jaune est initialement telle que leur mélange donne une sensation visuelle de couleur blanche, du fait du passage dans la vitrocéramique, l'absorption n'étant pas homogène (bleu fortement absorbé, jaune moins), l'oeil ne perçoit plus du blanc à travers la vitrocéramique, mais perçoit par exemple du rose, de l'orange ou du rouge.

De même, l'utilisation de LEDs à émissions polychromatiques (par exemple formées de trois sources monochromatiques d'intensités réglées de manière indépendante, telles que des LEDs de type « RGB » avec trois sources : rouge, verte et bleue) afin de donner par exemple du blanc, n'est pas appropriée, l'absorption inhomogène de la vitrocéramique sur le domaine visible déséquilibrant la balance entre les couleurs, et produisant également un rendu rose, orange ou rouge. On peut ajuster l'intensité respective des composantes RGB, mais le mélange doit être parfait (notamment spatialement - bon recouvrement des faisceaux lumineux - et temporellement - même phase d'une éventuelle modulation d'amplitude des faisceaux notamment) sous peine d'inhomogénéités ; l'espacement des trois zones émissives est souvent cause d'un mauvais mélange, entrainant une couleur non uniforme. De même, les 3 puces R, G et B subissent des dérives thermiques et des vieillissements différents, laissant apparaître dans le temps des inhomogénéités colorimétriques. Selon les lots de fabrication des LEDs rouge, verte et bleue, on observe en outre des variations de couleur d'une LED RGB à une autre. Les LEDs RGB sont également plus volumineuses que les LEDs habituellement utilisées pour les afficheurs et s'intègrent plus difficilement sur un bandeau de commande.

Pour ces raisons, l'affichage en blanc ou pour une majorité de couleurs autres que rouge, en particulier pour des couleurs de synthèse, est absent des vitrocéramiques, notamment sombres ou colorées, du fait de leur absorption inhomogène sur le domaine du visible, une lumière non monochromatique les traversant voyant sa couleur modifiée, ceci étant d'autant plus critique que son spectre est large, comme pour les sources blanches. Le document WO 2011/089327 décrit toutefois un ensemble d'affichage comprenant une plaque en vitrocéramique et au moins une source lumineuse polychromatique, telle qu'une LED blanche, présentant notamment une émission d'intensité non nulle à une longueur d'onde comprise entre 400 et 500 nm.

Le but de la présente invention a donc été de fournir de nouveaux articles vitrocéramiques (tels que des plaques) améliorés, en particulier de mettre au point de nouveaux articles vitrocéramiques présentant un affichage lumineux coloré plus varié, notamment autre que rouge, et en particulier blanc, cet affichage ne présentant pas les inconvénients précédemment cités, offrant une gamme de couleurs précise, et s'appliquant en particulier et avantageusement aux plaques de couleur sombre et/ou très absorbantes et/ou elles-mêmes colorées.

Ce but est atteint par le nouvel article selon l'invention comme défini dans la revendication 1. Cet article notamment, présente au moins une zone lumineuse (en particulier d'affichage) colorée, en particulier blanche, et comprend au moins un substrat vitrocéramique (en particulier une plaque, destinée par exemple à couvrir ou recevoir au moins un élément chauffant) ayant une transmission lumineuse allant de 0,8% à 40% et une transmission optique d'au moins 0,1% pour au moins une longueur d'onde comprise dans le domaine allant de 420 à 780 nm (situé dans le domaine du visible), au moins une source lumineuse (et/ou un afficheur intégrant ladite source), en particulier une diode électroluminescente (ou DEL ou LED en anglais), présentant un pic d'émission à une longueur d'onde comprise entre 430 et 490 nm (de préférence entre 440 et 485 nm), et au moins un composé (ou substance ou matière ou matériau) luminescent (ou 'phosphor' en anglais, en particulier et préférentiellement un composé fluorescent) émettant dans la zone (du diagramme trichromatique CIExyY (1931)) délimitée par les coordonnées (colorimétriques) (x, y) suivantes (cette zone étant appelée le cas échéant zone 1) :

| | | | | | |
|---|---|---|---|---|---|
| x | 0.2658 | 0.2000 | 0.3000 | 0.4229 | 0.2658 |
| y | 0.7243 | 0.3950 | 0.3405 | 0.5756 | 0.7243 |

ledit composé étant couplé (en fonctionnement) à ladite source (de même qu'à la plaque, la zone colorée obtenue résultant notamment de (l'action/l'effet de) ces trois composants)), de façon à former au moins une zone lumineuse, notamment un affichage (visualisation de données/ signalisation ou motifs décoratifs par exemple), colorée, en particulier blanche, en au moins une zone de la plaque. Comme explicité ultérieurement, ce composé (généralement sous forme d'une couche) peut être notamment combiné (en termes de positionnement) à la source et/ou à la plaque.

Les coordonnées (x, y) du système colorimétrique CIE 1931 (Commission internationale de l'éclairage, 1931) ci-avant mentionnées pour qualifier l'émission du composé luminescent sont mesurées par spectrofluoromètre (spectrophotomètre analysant la fluorescence d'un échantillon) mesurant le spectre d'émission du composé, la mesure étant réalisée en excitant le composé à la longueur d'onde du pic principal de la source lumineuse utilisée selon l'invention, les coordonnées (x, y) du modèle CIE 1931 étant ensuite obtenues selon la norme ISO 11664-3 : 2012 à partir de ce spectre.

De façon préférée, le composé luminescent sélectionné selon l'invention est un composé émettant dans la zone du diagramme trichromatique CIExyY (1931) délimitée par les coordonnées (x, y) suivantes (cette zone étant appelée le cas échéant zone 2) :

| | | | | | | | |
|---|---|---|---|---|---|---|---|
| x | 0.3231 | 0.2702 | 0.2000 | 0.2550 | 0.3600 | 0.4087 | 0.3231 |
| y | 0.6722 | 0.6158 | 0.3950 | 0.3650 | 0.5300 | 0.5896 | 0.6722 |

et de façon particulièrement préférée est un composé émettant dans la zone du diagramme trichromatique CIExyY (1931) délimitée par les coordonnées (x, y) suivantes (cette zone étant appelée le cas échéant zone 3) :

| | | | | | | | |
|---|---|---|---|---|---|---|---|
| x | 0.3231 | 0.2702 | 0.2000 | 0.2550 | 0.3451 | 0.3980 | 0.3231 |
| y | 0.6722 | 0.6158 | 0.3950 | 0.3650 | 0.5437 | 0.6001 | 0.6722 |

De façon particulièrement préférée, ce composé luminescent présente en outre un pic d'émission à une longueur d'onde comprise entre 500 et 575 nm (et de préférence inférieur à 570 nm, en particulier inférieur à 560 nm) et de largeur à mi-hauteur comprise entre 50 et 145 nm (et de préférence inférieure à 140 nm, en particulier inférieure à 125 nm).

Selon la présente invention, la source lumineuse (ou source de lumière), en particulier la diode électroluminescente, telle que sélectionnée, émet un rayonnement caractérisé par un pic (au moins un pic principal ou majoritaire ou d'intensité maximale) dans la gamme de longueurs d'onde comprise entre 430 et 490 nm (correspondant à une couleur bleue), dirigé vers une portion du substrat vitrocéramique, ce rayonnement étant absorbé de façon plus ou moins importante par le composé luminescent sélectionné, associé (notamment par dépôt sur la source ou par dépôt sur le substrat vitrocéramique sur le trajet du rayonnement) à ladite source, ledit composé luminescent tel que sélectionné (ré)émettant une lumière correspondant essentiellement à une couleur verte, ou éventuellement bleu-vert, telle qu'elle apparaît dans le diagramme trichromatique CIExyY (1931), et résultant en combinaison avec la lumière bleue issue de la source et transmise par le milieu luminescent (formé du composé luminescent et, le cas échéant, du liant ou de la matrice l'incorporant), après passage au travers du substrat vitrocéramique de caractéristiques telles que définies selon l'invention, en l'illumination d'une portion dudit substrat dans une gamme de couleur spécifique autre que rouge, en particulier dans une plage de blanc préférentiellement recherchée selon l'invention, cette plage de blanc présentant les coordonnées colorimétriques (x, y) suivantes (dans le diagramme trichromatique CIExyY (1931)) :

| | | | | | | | | | |
|---|---|---|---|---|---|---|---|---|---|
| x | 0.4791 | 0.3983 | 0.3382 | 0.2668 | 0.2810 | 0.3523 | 0.4124 | 0.4932 | 0.4791 |
| y | 0.4217 | 0.3979 | 0.3590 | 0.2877 | 0.2735 | 0.3449 | 0.3838 | 0.4076 | 0.4217 |

(ou encore plage de blanc correspondant au corps noir entre 2500K et 10500K, l'article selon l'invention utilisant un ou des composés luminescents (de la zone 1) tels que définis selon l'invention permettant avantageusement l'obtention de zones lumineuses dans une telle plage de blanc).

De façon particulièrement préférée, cette plage de blanc présente les coordonnées colorimétriques (x, y) suivantes :

| | | | | | | | |
|---|---|---|---|---|---|---|---|
| x | 0.4039 | 0.3381 | 0.2801 | 0.2942 | 0.3523 | 0.4181 | 0.4039 |
| y | 0.4005 | 0.3589 | 0.3032 | 0.2891 | 0.3448 | 0.3864 | 0.4005 |

(ou encore plage de blanc correspondant au corps noir entre 3500K et 8500K, l'article selon l'invention utilisant un ou des composés luminescents de la zone 2 permettant avantageusement l'obtention de zones lumineuses dans une telle plage de blanc), et en particulier elle présente avantageusement les coordonnées colorimétriques (x, y) suivantes :

| | | | | | | | |
|---|---|---|---|---|---|---|---|
| x | 0.3409 | 0.3001 | 0.2800 | 0.2942 | 0.3142 | 0.3550 | 0.3409 |
| y | 0.3609 | 0.3245 | 0.3031 | 0.2889 | 0.3104 | 0.3468 | 0.3609 |

(ou encore plage de blanc correspondant au corps noir entre 5000K et 8500K l'article selon l'invention utilisant un ou des composés luminescents de la zone 3 permettant avantageusement l'obtention de zones lumineuses dans une telle plage de blanc).

Avantageusement, la source lumineuse sélectionnée selon l'invention est une source monochromatique (couleur pure), c'est-à-dire que (le spectre d'émission de) la source (donnant l'intensité lumineuse émise en fonction de la longueur d'onde) présente un seul pic d'émission dans la gamme des longueurs d'onde visibles. En outre, la largeur du pic (majoritaire ou unique) de la source varie avantageusement de 1 à 100 nm, préférentiellement de 5 à 50 nm.

Avantageusement également, le composé luminescent choisi selon l'invention présente un seul pic d'émission, la longueur d'onde du pic (majoritaire ou unique) se situant entre 500 et 575 nm, et de préférence étant inférieure à 570 nm, en particulier inférieure à 560 nm, la largeur du pic à mi-hauteur étant comprise entre 50 et 145 nm, et de préférence étant inférieure à 140 nm, en particulier inférieure à 125 nm.

Le composé luminescent est généralement à base d'au moins un matériau organique ou avantageusement minéral, et est noyé (ou incorporé) dans une résine ou médium ou matrice permettant son application, l'ensemble se présentant généralement sous forme de film ou couche ou galette (couche réalisée à part, par exemple dans un moule, et qui peut ensuite être rapportée), etc, la résine étant avantageusement (semi-)transparente (en particulier transparente ou en partie diffusante) et présentant de préférence une transmission lumineuse (mesurée selon la norme ISO 9050 : 2003 par exemple par spectrophotomètre) d'au moins 50%, notamment d'au moins 80%, et en particulier d'au moins 90% dans le visible). L'action de ce composé/cet ensemble (ou milieu luminescent) sur la transmission de la lumière se fait par absorption d'une certaine partie de la lumière incidente à certaines longueurs d'onde, la lumière absorbée étant réémise (au moins en partie, voire en totalité) à d'autres longueurs d'onde. Le composé/l'ensemble peut être rapporté (fabriqué séparément), et combiné notamment à la source lumineuse (ou à plusieurs sources lumineuses) et/ou au substrat vitrocéramique, ou il peut être intégré ou réalisé directement sur le substrat vitrocéramique et/ou éventuellement sur au moins une source lumineuse et/ou un élément intermédiaire, comme explicité ultérieurement. Au moins une source lumineuse telle que sélectionnée selon l'invention est couplée (en fonctionnement) à au moins un tel composé correctif (c'est-à-dire que son rayonnement émis passe par ledit composé) afin de produire l'affichage recherché au travers du substrat vitrocéramique auquel cet ensemble source/composé luminescent est combiné.

Selon l'invention, le composé luminescent est choisi en fonction de la source lumineuse de sorte que la portion de lumière émise par la source et transmise au travers du composé luminescent présente les coordonnées colorimétriques (x, y) (dans le diagramme trichromatique CIExyY (1931)) suivantes (ou de façon à ce que l'ensemble source/milieu luminescent émette dans la zone du diagramme trichromatique CIExyY (1931) délimitée par les coordonnées (x, y) suivantes) :

| | | | | | | | | | |
|---|---|---|---|---|---|---|---|---|---|
| x | 0.460 | 0.385 | 0.255 | 0.190 | 0.175 | 0.180 | 0.305 | 0.385 | 0.460 |
| y | 0.440 | 0.425 | 0.305 | 0.255 | 0.270 | 0.310 | 0.485 | 0.510 | 0.440 |

de façon à obtenir au travers du substrat sélectionné selon l'invention une zone de couleur, préférentiellement de couleur blanche (en particulier celle correspondant au corps noir entre 2500 et 10500K précédemment définie) telle que préférentiellement recherchée selon l'invention.

De façon préférée, ce composé est choisi par rapport à la source de sorte que la portion de lumière émise par la source et transmise au travers du composé luminescent présente les coordonnées colorimétriques (x, y) suivantes:

| | | | | | | | | | |
|---|---|---|---|---|---|---|---|---|---|
| x | 0.305 | 0.180 | 0.180 | 0.200 | 0.235 | 0.265 | 0.330 | 0.385 | 0.305 |
| y | 0.485 | 0.310 | 0.280 | 0.265 | 0.330 | 0.315 | 0.380 | 0.425 | 0.485 |

de façon à obtenir au travers du substrat sélectionné selon l'invention une zone de couleur blanche préférée (en particulier celle correspondant au corps noir entre 3500 et 8500K précédemment définie).

En particulier le composé luminescent est choisi de sorte que la portion de lumière émise par la source et transmise au travers du composé luminescent présente les coordonnées colorimétriques (x, y) suivantes:

| | | | | | | | |
|---|---|---|---|---|---|---|---|
| x | 0.260 | 0.180 | 0.200 | 0.235 | 0.265 | 0.330 | 0.260 |
| y | 0.420 | 0.280 | 0.265 | 0.330 | 0.315 | 0.380 | 0.420 |

de façon à obtenir au travers du substrat sélectionné selon l'invention une zone de couleur blanche particulièrement préférée (en particulier celle correspondant au corps noir entre 5000 et 8500K précédemment définie).

Afin d'obtenir une couleur de coordonnées précises données (en particulier un blanc de type blanc chaud ou blanc froid de coordonnées fixées) au travers d'une vitrocéramique donnée telle que définie selon l'invention, le composé luminescent selon l'invention le plus approprié parmi ceux sélectionnés, et la quantité appropriée de ce composé sont choisis et calculés, en fonction de la vitrocéramique (en l'occurrence de la transmission optique - ou transmission spectrale ou dispersion spectrale - du substrat vitrocéramique, la transmission optique/spectrale dépendant elle-même de la composition et de l'épaisseur dudit substrat), de la matrice dans laquelle le composé est incorporé le cas échéant, et de la source lumineuse précise utilisée, comme explicité ultérieurement.

L'article vitrocéramique selon l'invention et ses composants sont plus amplement détaillés dans la suite de la description.

Par articles (en) vitrocéramiques, on entend non seulement les articles réalisés en vitrocéramique proprement dite mais également les articles en tout autre matériau analogue convenant pour les mêmes applications (par exemple un verre renforcé ou non), en particulier résistant à haute température et/ou présentant notamment un coefficient de dilatation nul ou quasi-nul (par exemple inférieur à 15.10⁻⁷ K⁻¹, comme dans le cas des plaques vitrocéramiques utilisées avec des feux radiants). De préférence cependant, il s'agit d'un article en vitrocéramique proprement dite.

L'article selon l'invention peut être avantageusement une plaque de cuisson, mais peut être également tout autre article en vitrocéramique présentant un affichage fonctionnel ou décoratif, voire un article ou module ou ensemble ou système (à vocation principale) d'affichage (décoratif et/ou fonctionnel) avec au moins une source lumineuse couplée à au moins un composé correctif comme défini selon l'invention, cet ensemble étant couplé à au moins une vitrocéramique, en particulier plaque, conformément à l'invention.

De préférence, l'article selon l'invention est formé (comme substrat) d'une plaque vitrocéramique (d'épaisseur généralement comprise entre 3 et 4 mm, notamment de l'ordre de 4 mm), plane, ou majoritairement ou quasiment plane (en particulier avec une flèche inférieure à 0,1% de la diagonale de la plaque, et de préférence de l'ordre de zéro), et est destiné à servir de plaque de cuisson. Une telle plaque est généralement destinée à être intégrée dans une table de cuisson ou cuisinière comprenant ladite plaque et des éléments chauffants, par exemple des foyers radiants ou halogènes ou des éléments de chauffage par induction.

La plaque présente généralement une face "supérieure" (face visible) en position d'utilisation, une autre face "inférieure" (souvent cachée, dans le châssis ou caisson d'une cuisinière par exemple) en position d'utilisation, et une tranche (ou chant ou épaisseur). La face supérieure est généralement plane et lisse mais peut aussi présenter au moins une zone en relief et/ou au moins une zone en creux et/ou au moins une ouverture (par exemple si la plaque incorpore une ouverture destinée à recevoir un brûleur à gaz atmosphérique). La face inférieure peut être notamment lisse ou munie de picots augmentant sa résistance mécanique et obtenus par exemple par laminage. Le cas échéant, dans le cas de picots, une résine d'indice peut être appliquée sur la surface inférieure afin de la lisser, si nécessaire.

L'article selon l'invention est avantageusement à base de toute vitrocéramique ayant, de manière intrinsèque, une transmission lumineuse allant de 0,8% à 40% (en particulier de 2,3 à 40%) et une transmission optique (déterminée de façon connue en faisant le rapport entre l'intensité transmise et l'intensité incidente à une longueur d'onde donnée) d'au moins 0,1% pour au moins une longueur d'onde, comprise dans le domaine du visible, au-dessus de 420 nm (et jusqu'à 780 nm), et de préférence d'au moins 0.1% pour toutes les longueurs d'onde comprises dans le domaine allant de 420 à 780 nm. Par « de manière intrinsèque», on entend que la plaque possède une telle transmission en elle-même, sans la présence d'un quelconque revêtement. La transmission lumineuse est mesurée selon la norme ISO 9050 : 2003 (mentionnant également la transmission optique) en utilisant l'illuminant D65, et est la transmission totale (notamment intégrée dans le domaine du visible et pondérée par la courbe de sensibilité de l'oeil humain), tenant compte à la fois de la transmission directe et de l'éventuelle transmission diffuse, la mesure étant faite par exemple à l'aide d'un spectrophotomètre muni d'une sphère intégrante, la mesure à une épaisseur donnée étant ensuite convertie le cas échéant à l'épaisseur de référence de 4 mm selon la norme ISO 9050 : 2003. L'invention s'applique de façon particulièrement avantageuse aux plaques sombres, notamment d'aspect noir ou brun, présentant de tels critères de transmission, mais la vitrocéramique utilisée présentant de tels critères peut également être une vitrocéramique claire, la solution selon l'invention permettant d'obtenir l'affichage lumineux de la couleur précise désirée, avec une grande souplesse d'adaptation, pour toute cette gamme de plaques, de façon simple et sans risquer d'altérer d'autres propriétés des plaques.

Dans un premier mode de réalisation, la vitrocéramique est une vitrocéramique, en particulier sombre (notamment telle que la valeur de L* dans le système colorimétrique CIE, calculée à partir du spectre de transmission de ladite vitrocéramique sur le domaine du visible, soit inférieure à 70%), présentant une transmission lumineuse dans le visible de 0,8% à 5%, en particulier de 0,8 à 2,5%, et présentant une transmission optique supérieure à 0,1% pour au moins une longueur d'onde dans le domaine du visible supérieure à 450 nm.

Dans un autre mode de réalisation avantageux, la vitrocéramique, du type aluminosilicate de lithium, présente (de manière intrinsèque) une transmission lumineuse allant de 2,3% à 40%, en particulier supérieure à 2.5%, notamment supérieure à 3.5%, et une transmission optique d'au moins 0,6% pour au moins une longueur d'onde comprise dans le domaine allant de 420 à 480 nm. Dans ce cas, que la vitrocéramique soit claire ou sombre, elle présente de préférence au moins un moyen de masquage destiné à masquer au moins une partie des éléments sous-jacents associés (moyens de chauffage notamment) le cas échéant à l'exclusion des dispositifs émetteurs de lumière/des zones d'éclairage et le cas échéant de moyens de chauffage par rayonnement, le(s) sources lumineuses et composé(s) luminescent(s) selon l'invention étant dans ce cas essentiellement utilisé(s) dans les zones lumineuses non masquées.

En particulier, on utilise avantageusement une vitrocéramique comprenant les constituants suivants et/ou obtenue par céramisation à partir d'un verre de composition suivante, dans les limites ci-après exprimées en pourcentages pondéraux : SiO₂: 52 - 75 %; Al₂O₃ :18 - 27 %; Li₂O: 2,5 - 5,5 %; K₂O : 0 - 3 %; Na₂O : 0 - 3 %; :ZnO : 0 - 3,5 %; MgO : 0 - 3 %; CaO: 0 - 2,5%; BaO : 0 - 3,5 %; SrO : 0 - 2 %; TiO₂ :1,2 - 5,5 %; ZrO₂: 0 - 3 %; P₂O₅: 0 - 8 %, et de préférence, dans les limites ci-après exprimées en pourcentages pondéraux : SiO₂ :64 - 70 %; Al₂O₃ : 18 - 21 %; Li₂O : 2,5 - 3,9 %; K₂O : 0 - 1,0 %; Na₂O : 0 - 1,0 %; ZnO : 1,2 - 2,8 %; MgO : 0,20 - 1,5 %; CaO : 0 - 1%; BaO: 0 - 3 %; SrO: 0 - 1,4 %; TiO₂: 1,8 - 3,2 %; ZrO₂ : 1,0 - 2,5 %.

La vitrocéramique peut aussi comprendre jusqu'à 1 % en poids de constituants non essentiels n'affectant pas notamment la fusion du verre-mère ou la dévitrification ultérieure conduisant à la vitrocéramique. Des colorants peuvent en particulier être ajoutés à la composition à des taux limités (préférentiellement à un taux inférieur à 0,2%, en particulier inférieur à 0,15%, pour la somme des colorants), par exemple dans le cas des vitrocéramiques noires ou brunes. Par exemple, la composition de la plaque peut comprendre avantageusement de l'oxyde de vanadium (V₂O₅) à un taux compris entre 0,005 et 0,2%, notamment entre 0,01% et 0,2%, en particulier compris entre 0,01 et 0,1%, et de préférence inférieur ou égal à 0,05%, voire à 0,04%. Les teneurs préférées en oxyde de vanadium sont comprises entre 0,01 et 0,03%.

La vitrocéramique peut aussi contenir, pour cacher les éléments chauffants et éventuellement en combinaison avec l'oxyde de vanadium, les autres agents colorants suivants dans les limites pondérales suivantes (le substrat vitrocéramique comprenant préférentiellement moins de 0,2%, en particulier moins de 0,15%, d'agents colorants, comme indiqué précédemment): Fe₂O₃: 0 - 0,2 %; CoO : 0 - 1 %, de préférence 0 - 0,12%, et en particulier 0,01 - 0, 04% (Fe₂O₃,V₂O₅ et CoO étant les colorants préférentiellement utilisés), voire du NiO (en particulier à un taux inférieur à 0,005%, ce composé étant généralement présent à titre d'impureté), du CuO (en particulier à un taux inférieur à 0,005%, ce composé étant généralement présent à titre d'impureté) et/ou du MnO (préférentiellement à un taux inférieur à 0,05%, en particulier inférieur à 0,025%). La vitrocéramique peut également comprendre d'autres agents colorants à taux limités, en particulier peut comprendre moins de 1000 ppm (0-0,1%) de Rb₂O, généralement présent à titre d'impureté, ou moins de 1000 ppm (0 - 0,1%) de la somme des oxydes suivants : As₂O₃ + Sb₂O₃, la vitrocéramique étant en outre préférentiellement dénuée des agents P₂O₅, B₂O₃ et F. Afin d'obtenir en particulier une zone lumineuse blanche telle qu'avantageusement recherchée dans la présente invention, la vitrocéramique de l'article selon l'invention présente également de préférence un taux de Cr₂O₃ inférieur à 0,0015% (ou taux allant de 0 à 0,0015%), en particulier inférieur à 0,0012% voire inférieur ou égal à 0,001% en poids.

La vitrocéramique peut aussi comprendre de l'oxyde d'étain (ou d'autres réducteurs comme les sulfures métalliques) à un taux inférieur à 0,5% (ou de 0-0,5%), l'oxyde d'étain (SnO₂) permettant de favoriser la réduction du vanadium pendant l'étape de céramisation, entraînant notamment l'apparition de la couleur.

La vitrocéramique sombre préférée selon l'invention comprend généralement des cristaux de structure β-quartz au sein d'une phase vitreuse résiduelle, et la valeur absolue de son coefficient de dilatation est avantageusement inférieure ou égale à 15.10⁻⁷/°C, voire à 5.10⁻⁷/°C.

Par la sélection de vitrocéramiques, qui bien que sombres le cas échéant, présentent des transmissions lumineuse et optique sélectionnées décrites ci-avant, et leur combinaison aux moyens d'éclairage (source(s) et composé(s) luminescent(s)) sélectionnés, afin de compenser ou corriger, de façon contrôlée, la dispersion spectrale de la vitrocéramique, on peut obtenir le rendu blanc souhaité. L'invention convient aux plaques vitrocéramiques sombres ou colorées remplissant les critères de transmission, qu'elle dote d'une fonction de coloration contrôlée de l'affichage.

L'article selon l'invention comprend au moins une source lumineuse telle que définie selon l'invention, l'article pouvant également le cas échéant comprendre plusieurs sources (leur nombre et leur disposition pouvant varier pour homogénéiser l'éclairage). La ou les sources peuvent être intégrées dans/couplées à une ou des structure(s) de type afficheur(s) (par exemple à diodes électroluminescentes dits « à 7 segments »), à un bandeau de commande électronique à touches sensitives et affichage digital, etc. Comme déjà évoqué, les sources lumineuses sont avantageusement formées par des diodes électroluminescentes, plus ou moins espacées, éventuellement associées à un ou plusieurs guides optiques comme mentionné ultérieurement. Les diodes sont avantageuses dans la présente invention en terme notamment d'encombrement, d'efficacité, de pérennité et de résistance aux conditions environnantes (chaleur...).

Les diodes peuvent être encapsulées, c'est-à-dire comprendre un composant semi-conducteur et une enveloppe (par exemple en résine type époxy ou nylon ou silicone), encapsulant le composant semi-conducteur. Les diodes peuvent aussi être des puces semi-conductrices sans lentilles de collimation par exemple de taille de l'ordre de la centaine de µm ou du mm, éventuellement avec une encapsulation minime (par exemple de protection).

Les diodes peuvent être portées par un support ou barrette ou embase, cette embase pouvant présenter une surface (plane ou inclinée) traitée et/ou rendue réfléchissante pour une meilleure efficacité lumineuse, par exemple revêtue d'une laque ou peinture et/ou couche miroir, et/ou couplée à un réflecteur blanc ou métallique pour mieux diriger le rayonnement émis.

L'assemblage de la ou des sources (à la plaque ou à un autre constituant de l'article comme par exemple le bandeau de commande) peut se faire par soudure, clipsage, collage, etc, le cas échéant par l'intermédiaire d'un autre élément ; par exemple, on peut monter des diodes, soudées sur un support lui-même logé au fond d'un profilé métallique, par clipsage ou collage du profilé. Le positionnement de la ou des sources (par rapport à la plaque notamment) est adapté pour permettre un affichage au travers de la vitrocéramique.

Les sources, ainsi que leur alimentation et actionnement, peuvent être dissociés ou non de façon à permettre un éclairage simultané ou séparé des zones d'éclairage voulues selon les besoins.

On peut notamment utiliser comme sources des LEDs fabriquées par exemple à partir d'une puce de cristal semi-conducteur tel que le nitrure de gallium/indium (InGaN) émettant dans le bleu. Comme exemples de LEDs avantageuses, on peut citer notamment les LEDs ou afficheurs suivants : la référence VLMB1300-GS08 de la société Vishay, les références KPT-1608QBC-G, APG1608QBC/F, ou SA39-1 1 PBWA de la société KingBright, la référence LB Q39G-N1P1-1 de la société OSRAM, la référence LCS-10012TB11 de la société LC LED, etc. A noter que les afficheurs à LED(s) sont des dispositifs d'affichage lumineux dont la source lumineuse « primaire » est constituée de LED(s), ces dispositifs étant généralement composés de « segments » lumineux (par exemple afficheurs à 7 segments), de points (afficheurs matriciels) ou de barres, un segment étant généralement formé par un réflecteur, la ou les LEDs étant généralement insérée(s) à une extrémité du réflecteur et la lumière guidée jusqu'à l'autre l'extrémité (apparente), les parois internes du réflecteur pouvant être diffusantes et/ou l'extrémité apparente du segment pouvant être recouverte d'un matériau plastique de transparence élevée.

Comme déjà évoqué, l'article peut comprendre, outre la ou les sources, au moins un guide d'onde destiné à propager la lumière d'une partie à l'autre de l'article (en particulier par réflexion totale interne ou par réflexion métallique), la source lumineuse étant alors rattachée au guide et coopérant avec celui-ci en émettant en son sein son rayonnement lumineux afin que le guide le transmette, la ou les sources lumineuses émettant/étant couplées par exemple par la tranche ou chant du guide. Ce guide est avantageusement clair ou transparent, et est généralement rapporté (assemblé après avoir été conçu séparément) sur la face inférieure du substrat, Il peut être organique et/ou plastique (par exemple en polycarbonate ou polyméthacrylate de méthyle PMMA), ou minéral, et est de préférence minéral ; en particulier, il s'agit d'un verre. L'article selon l'invention peut comprendre plusieurs guides dédiés chacun à une ou plusieurs zones d'éclairage, ou un guide unitaire, pourvu le cas échéant d'ouvertures. Le guide peut être solidarisé au substrat par collage et/ou clipsage, ou par encapsulation, etc. L'assemblage du guide peut se faire directement sur le substrat ou sur une autre partie de l'article ou d'un support sur lequel est monté l'article, par exemple dans le cas d'un module ou appareil de cuisson, le guide peut être solidarisé au caisson de l'appareil de cuisson sur lequel le substrat est monté (le caisson pouvant le cas échéant faire partie de l'article). Le guide permet, entre autres, de mieux conduire la lumière jusqu'aux zones d'éclairage voulues, en particulier lorsque le substrat est de couleur sombre.

L'article selon l'invention peut aussi comprendre dans la zone d'éclairage, au moins un moyen d'extraction du rayonnement (émis par la ou les sources et conduit le cas échéant par le guide d'onde), par exemple un ou des éléments ou traitement(s) diffusants, en particulier un moyen d'extraction tel qu'une couche rapportée sur la surface, et/ou tout traitement ou texturation différentielle de la surface (local ou sur toute la surface) par exemple du guide d'onde, comme la gravure laser, l'impression d'émail, l'attaque chimique (acide..) ou mécanique (sablage...), etc, le moyen d'extraction pouvant également être constitué, en partie ou en totalité, par le milieu luminescent associé à la source lumineuse (par exemple dans le cas où des particules diffusantes sont ajoutées au liant intégrant le composé luminescent selon l'invention). Une surface d'extraction peut également être prévue, par exemple dans l'épaisseur du guide le cas échéant, suivant par exemple une technologie de gravure interne par laser. Le ou les moyens d'extraction permettent d'extraire les rayonnements du guide vers la zone d'éclairage voulue. Le cas échéant, la géométrie et la rugosité du bord d'un guide d'onde peuvent également être travaillées pour permettre une extraction locale et contrôlée de la lumière. Le ou les moyens d'extraction peuvent être combinés le cas échéant avec un autre traitement permettant de cibler les zones d'éclairage, par exemple avec une sérigraphie occultante (masquant certaines zones et empêchant le passage de la lumière) sur le substrat. Comme défini selon l'invention, la ou les sources utilisées sont combinées avec un composé luminescent au travers duquel passent les rayonnements émis par la ou les sources (et transmis le cas échéant par le guide d'onde et les moyens d'extraction éventuels). Ce composé est généralement placé (et occupe en particulier une position fixe) entre la source et le substrat et peut être solidarisé (c'est-à-dire directement, ou indirectement (par exemple par l'intermédiaire d'un autre constituant) fixé, et inamovible de façon simple une fois placé) à la source et/ou au substrat, et/ou éventuellement à un autre élément intermédiaire (par exemple un moyen d'extraction de la lumière tel que précité).

Ce composé est généralement intégré (en particulier par mélange, par exemple à l'aide d'un agitateur, avant éventuellement cuisson ou durcissement du mélange) dans une matrice ou résine ou un liant comme déjà évoqué, organique (ou polymérique) ou inorganique, préférentiellement transparent, et éventuellement diffusant, par exemple un liant (ou résine) acrylate, epoxy ou silicone, ou sol-gel, etc, par exemple une résine de référence Sylgard 184 Silicone Elastomer ou OE-6635 de la société Dow Corning, etc. Le composé luminescent peut être un composé organique ou de préférence inorganique, le cas échéant dopé (par exemple de type aluminate ou silicate dopé europium), et est de préférence un composé fluorescent (émettant immédiatement la lumière après excitation). Il s'agit préférentiellement d'un seul composé (présentant préférentiellement un seul pic d'émission), déposé sous forme d'une couche, mais il est également possible le cas échéant d'utiliser plusieurs composés (le mélange résultant présentant les caractéristiques du composé luminescent tel que sélectionné dans la présente invention) et/ou plusieurs couches de composé(s) superposées ou combinées.

Le composé (dans son liant éventuel) est généralement déposé sous forme d'une ou plusieurs couches (généralement de quelques dizaines à plusieurs centaines de microns d'épaisseur), par exemple au rouleau, par pulvérisation, par dépôt à la tournette, sérigraphie, jet d'encre, etc., et solidarisé (directement ou par exemple par ajout de colle si nécessaire, notamment s'il est déposé ou intégré à un élément intermédiaire puis rapporté) à la surface notamment de la ou des sources ou de la vitrocéramique.

Dans un premier mode de réalisation avantageux, il est déposé sur (ou monté sur) et solidaire de (ou fixé sur) la source lumineuse. De préférence, le dépôt est limité à la surface émettrice de la puce et est d'épaisseur constante afin de garantir que la couleur de la lumière émise reste uniforme selon l'angle d'observation (dépôt dit conforme).

Dans un second mode de réalisation avantageux, le composé (dans son liant éventuel) est déposé sur et solidaire de (ou fixé sur) la vitrocéramique, préférentiellement la face inférieure de la vitrocéramique.

De préférence, le milieu luminescent (composé sélectionné selon l'invention, et matrice ou liant l'incorporant le cas échéant) présente une absorbance A_{λ} supérieure à 0.274, et de préférence supérieure à 0.297 à la longueur d'onde (du pic principal ou unique) λ d'émission de la source utilisée à laquelle il est combiné. L'absorbance A_{λ} = log₁₀ (I₀/I), I₀ étant l'intensité lumineuse incidente et I étant l'intensité lumineuse transmise, et est mesurée par un spectrophotomètre.

Comme déjà indiqué, le choix du composé pour obtenir la couleur cible recherchée (telle que perçue visuellement) est fonction de la plaque vitrocéramique utilisée, du liant ou de la matrice incorporant le composé, de la couleur recherchée et de la source utilisée. En particulier, afin d'obtenir une couleur (avantageusement blanche) de coordonnées colorimétriques données ou dans une plage donnée, on procède comme suit :
1) On place dans le diagramme trichromatique CIExyY (1931) la ou les couleurs cibles,
2) On place dans le diagramme trichromatique CIExyY (1931) le point (xₛ,yₛ) correspondant à la source choisie (sélectionnée selon l'invention) vue à travers le substrat vitrocéramique (on mesure le spectre d'émission de la source après transmission par la vitrocéramique, suivant la norme CIE 127-2007, puis on calcule les coordonnées associées (x,y) du modèle CIE 1931 suivant la norme ISO 11664-3:2012),
3) On place dans le diagramme trichromatique CIExyY (1931) le point (xₗ,yₗ) correspondant au milieu luminescent (composé luminescent tel que défini selon l'invention et le cas échéant matrice l'incorporant) sélectionné vu à travers la plaque vitrocéramique,
4) L'ensemble des couleurs synthétisables par cette combinaison correspond à la droite reliant les points placés sur le diagramme à l'étape 2) et à l'étape 3). Si cette droite coupe le point ou la zone de points défini(e) à l'étape 1) (à une distance inférieure à 0.01, préférentiellement inférieure à 0.001, voire nulle), on retient cette combinaison source + milieu luminescent, et on passe à l'étape 5) pour déterminer la quantité de composé luminescent à utiliser. Sinon, on recommence l'étape 3) avec un autre composé luminescent sélectionné selon l'invention jusqu'à ce que la droite tracée coupe le point ou la zone de points défini(e) à l'étape 1) et que l'on puisse ainsi sélectionner le composé luminescent (et le cas échéant son milieu d'incorporation) le plus approprié pour obtenir la couleur cible.
5) On relève les coordonnées (x_{c}, y_{c}) du point d'intersection (qui minimise la distance à la cible) obtenu à l'étape 4). Ce point d'intersection est le barycentre des points définis à l'étape 2) et 3), affectés respectivement des coefficients α et β tels que α = (x_{c} - xₗ) / (xₛ - xₗ) et β = (x_{c} - xₛ) / (xₗ - xₛ). La quantité de composé luminescent à utiliser doit être telle que, pour une intensité lumineuse totale (Iₜ) émise par la source (mesurée suivant la norme CIE 127-2007), la lumière issue de la source apporte une contribution de α x Iₜ. et la lumière issue du composé luminescent apporte une contribution de β x Iₜ. Cette quantité est ainsi déterminée, par exemple, en réalisant plusieurs dépôts du liant ou de la matrice incorporant le composé luminescent en faisant varier la concentration dudit composé et/ou l'épaisseur (du milieu luminescent) déposée, puis en sélectionnant l'échantillon qui permet d'atteindre le point de couleur souhaité à travers la vitrocéramique, ou encore en mesurant le spectre d'émission des échantillons, calculant le rapport entre l'intensité lumineuse du pic du composé luminescent et l'intensité lumineuse du pic de la source, et sélectionnant l'échantillon pour lequel ce rapport est égal à β/α.

La combinaison source/composé luminescent/vitrocéramique selon l'invention permet d'obtenir un affichage blanc au travers de la vitrocéramique, donnant accès à des effets lumineux particulièrement recherchés en termes de design. L'article selon l'invention peut ainsi présenter une ou plusieurs zones lumineuses/d'affichage à usage fonctionnel et/ou décoratif (dessin, logo, signalisation alphanumérique, etc), généralement observées en faces principales (notamment la face supérieure) du substrat vitrocéramique. La ou lesdites zones peuvent être dans toute zone de la plaque (y compris zones de chauffe), et l'on peut avoir plusieurs zones lumineuses/d'affichage différenciées, avec un niveau de luminance supérieur à 10 candela/m² (grandeur définie selon la norme ISO 23539 : 2005(E)), en particulier supérieur à 20 candela/m², et notamment supérieur à 50, voire 70 candela/m².

L'article selon l'invention peut comporter le cas échéant d'autres éléments et/ou couches que les constituants précités. Par exemple, lorsqu'il s'agit d'un module de cuisson, l'article peut être muni de (ou associée avec des) élément(s) fonctionnel(s) ou de décor supplémentaire(s) (cadre, connecteur(s), câble(s), élément(s) de commande), etc. Il peut comporter divers revêtements fonctionnels et/ou décoratifs, à base d'émail, de peinture, etc. Par exemple, l'une des faces du substrat peut comporter une couche d'émail de décoration, de masquage (pour éviter par exemple la vision directe des sources), ou d'autre fonction (homogénéisation de l'éclairage, etc.).

L'invention concerne aussi les appareils (ou dispositifs) de cuisson et/ou de maintien à haute température comportant au moins un article selon l'invention (par exemple cuisinières, tables de cuisson encastrables, fours, etc) et comportant, le cas échéant, un ou plusieurs éléments chauffants tels qu'un ou plusieurs éléments radiants ou halogènes et/ou un ou plusieurs brûleurs à gaz atmosphérique et/ou un ou plusieurs moyens de chauffage par induction. L'article selon l'invention peut également consister en un appareil de cuisson comportant un ou plusieurs éléments chauffants outre les éléments précités dans la définition de l'invention. L'invention englobe aussi bien des appareils de cuisson comportant une seule plaque que des appareils comportant plusieurs plaques, chacune de ces plaques étant le cas échéant à feu unique ou à feux multiples. Par le terme « feu », on entend un emplacement de cuisson. L'invention concerne également des appareils de cuisson mixtes dont la ou les plaques de cuisson comportent plusieurs types de feux (feux à gaz, feux radiants, halogènes ou à induction). En outre, l'invention n'est pas limitée à la fabrication de plaques ou modules de cuisson pour cuisinières ou tables de cuisson. Les articles fabriqués conformément à l'invention peuvent également être d'autres modules plans ou plaques devant présenter une grande insensibilité aux variations de température.

L'appareil de cuisson, outre les éléments internes de chauffage, comprend aussi généralement des moyens de commande et/ou de contrôle, les éléments internes étant recouverts par le substrat vitrocéramique, l'affichage autre que rouge étant vu au travers dudit substrat, pourvu le cas échéant, en une face ou en son sein d'au moins un moyen de masquage destiné à masquer au moins une partie desdits éléments internes.

La présente invention concerne également un procédé de fabrication d'un article selon l'invention, dans lequel on insère entre la plaque vitrocéramique et au moins une source, au moins un composé luminescent tel que mentionné précédemment selon l'invention, en particulier choisi selon le procédé de sélection précédemment évoqué. Ce composé peut être inséré sous forme d'un élément indépendant (par exemple on rapporte le composé dans son liant, préalablement fabriqués sous forme d'une galette, en particulier on l'assemble au substrat vitrocéramique ou à la source) ou d'une couche déposée sur la source ou le substrat vitrocéramique comme précédemment évoqué. Ce composé peut également avoir été au préalable déposé sur la source avant ajout de l'ensemble au substrat vitrocéramique (on peut notamment utiliser une source intégrant déjà ce composé luminescent). On insère avantageusement ce composé ou l'élément intégrant ce composé (par exemple la source recouverte de ce composé) après céramisation du verre précurseur (ou verre-mère ou green glass) pour obtenir le substrat vitrocéramique.

Pour mémoire, la fabrication des plaques vitrocéramiques s'opère généralement comme suit : dans un four de fusion, on fond le verre de composition choisie pour former la vitrocéramique, puis on lamine le verre fondu en un ruban ou feuille standard en faisant passer le verre fondu entre des rouleaux de laminage et on découpe le ruban de verre aux dimensions souhaitées. Les plaques ainsi découpées sont ensuite céramisées de manière connue en soi, la céramisation consistant à cuire les plaques suivant le profil thermique choisi pour transformer le verre en le matériau polycristallin appelé « vitrocéramique » dont le coefficient de dilatation est nul ou quasi-nul et qui résiste à un choc thermique pouvant aller jusqu'à 700°C. La céramisation comprend généralement une étape d'élévation progressive de la température jusqu'au domaine de nucléation, généralement situé au voisinage du domaine de transformation du verre, une étape de traversée en plusieurs minutes de l'intervalle de nucléation, une nouvelle élévation progressive de la température jusqu'à la température du palier de céramisation, le maintien de la température du palier de céramisation pendant plusieurs minutes puis un refroidissement rapide jusqu'à la température ambiante. Le cas échéant, le procédé comprend également une opération de découpe (généralement avant céramisation), par exemple par jet d'eau, traçage mécanique à la molette, etc. suivie par une opération de façonnage (meulage, biseautage,...).

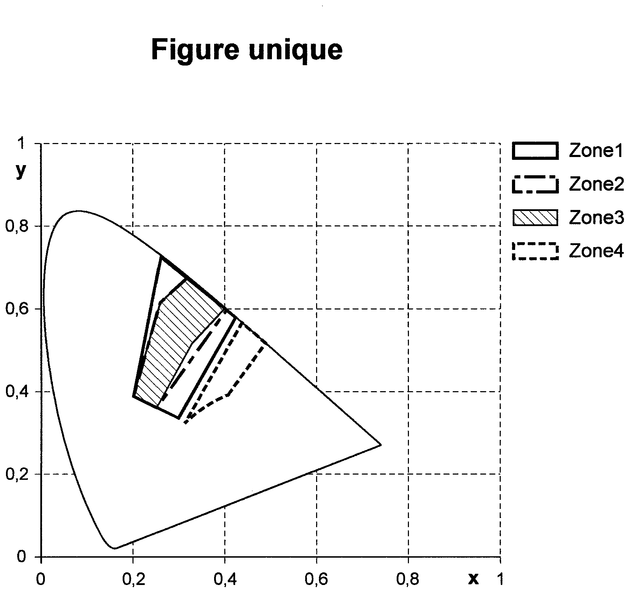

A titre illustratif, la figure annexée représente, dans le diagramme colorimétrique CIE 1931, les zones d'émission du composé luminescent sélectionné selon l'invention, permettant d'obtenir du blanc au travers de la vitrocéramique sélectionnée selon l'invention. En particulier, la zone 1 représente la zone de coordonnées colorimétriques suivantes :

| | | | | | |
|---|---|---|---|---|---|
| x | 0.2658 | 0.2000 | 0.3000 | 0.4229 | 0.2658 |
| y | 0.7243 | 0.3950 | 0.3405 | 0.5756 | 0.7243 |

La zone 2 représente la zone préférée de coordonnées suivantes :

| | | | | | | | |
|---|---|---|---|---|---|---|---|
| x | 0.3231 | 0.2702 | 0.2000 | 0.2550 | 0.3600 | 0.4087 | 0.3231 |
| y | 0.6722 | 0.6158 | 0.3950 | 0.3650 | 0.5300 | 0.5896 | 0.6722 |

La zone 3 représente la zone particulièrement préférée de coordonnées suivantes :

| | | | | | | | |
|---|---|---|---|---|---|---|---|
| x | 0.3231 | 0.2702 | 0.2000 | 0.2550 | 0.3451 | 0.3980 | 0.3231 |
| y | 0.6722 | 0.6158 | 0.3950 | 0.3650 | 0.5437 | 0.6001 | 0.6722 |

A titre de référence, la zone 4 représente la zone d'émission (correspondant à une couleur jaune) des éléments luminescents actuellement utilisés dans les LEDs blanches actuelles formées d'une source de lumière bleue recouverte d'un élément absorbant une partie de ladite lumière et réémettant de la lumière jaune, ces leds blanches ne permettant pas d'obtenir une couleur blanche à travers une vitrocéramique, comme recherché selon l'invention, l'oeil percevant plutôt du rose, de l'orange ou du rouge dans ce cas.

L'exemple suivant illustre en outre de manière non limitative la présente invention.

Dans cet exemple, l'article réalisé est un module de cuisson plan comprenant une plaque vitrocéramique (substrat), commercialisée sous la référence KeraVision par la société Eurokera, cette plaque présentant une face supérieure lisse et une face inférieure lisse, l'article comprenant en outre une source lumineuse fixée sous la plaque contre celle-ci.

On utilise comme source lumineuse, un afficheur à leds, chaque led présentant un pic d'émission à une longueur d'onde de 472 nm et de largeur à mi-hauteur de 25 nm. En outre, on utilise comme composé luminescent un composé de référence EG3560 (à base de silicate dopé europium) de la société Intematix, présentant un pic d'émission à une longueur d'onde de 535 nm et de largeur à mi-hauteur de 80 nm et de coordonnées colorimétriques suivantes : x = 0.345 (+/-0.005) ; y = 0.602 (+/0.005). Ce composé, sous forme de poudre, est mélangé à la spatule à une résine acrylate sous forme liquide commercialisée sous la référence NOA81 par la société Epotecny, à raison de 1.5 g de poudre dudit composé pour 1 ml de résine. Le mélange luminescent obtenu est déposé par dépôt à la tournette, à une épaisseur de 230 µm directement sur la plaque de vitrocéramique. En fonctionnement, la source émet un faisceau lumineux qui traverse l'ensemble mélange luminescent/plaque au niveau de la zone d'affichage. L'affichage obtenu est de couleur blanche, de coordonnées colorimétriques suivantes : x=0.341 ; y = 0.365.

Les articles, en particulier plaques, selon l'invention peuvent notamment être utilisées avec avantage pour réaliser une nouvelle gamme de plaques de cuisson pour cuisinières ou tables de cuisson, mais peuvent également être utilisés avec avantages pour réaliser des éléments de paroi ou des parois (par exemple des portes ou partie de portes) de fours, etc.

## Revendications

1. Article présentant au moins une zone, en particulier d'affichage, lumineuse, en particulier blanche, ledit article comprenant au moins un substrat vitrocéramique ayant une transmission lumineuse allant de 0,8% à 40% et une transmission optique d'au moins 0,1% pour au moins une longueur d'onde comprise dans le domaine allant de 420 à 780 nm, au moins une source lumineuse, en particulier une diode électroluminescente, présentant un pic d'émission à une longueur d'onde comprise entre 430 et 490 nm, et au moins un composé luminescent émettant dans la zone délimitée par les coordonnées colorimétriques (x, y) suivantes :
| | | | | | |
|---|---|---|---|---|---|
| x | 0.2658 | 0.2000 | 0.3000 | 0.4229 | 0.2658 |
| y | 0.7243 | 0.3950 | 0.3405 | 0.5756 | 0.7243 |
de façon à former au moins une zone, en particulier d'affichage, lumineuse, en particulier blanche, en au moins une zone de la plaque, ledit composé luminescent étant en outre choisi de sorte que l'ensemble source/milieu luminescent émette dans la zone délimitée par les coordonnées colorimétriques (x, y) suivantes:
| | | | | | | | | | |
|---|---|---|---|---|---|---|---|---|---|
| x | 0.460 | 0.385 | 0.255 | 0.190 | 0.175 | 0.180 | 0.305 | 0.385 | 0.460 |
| y | 0.440 | 0.425 | 0.305 | 0.255 | 0.270 | 0.310 | 0.485 | 0.510 | 0.440 |

2. Article selon la revendication 1, **caractérisé en ce que** le composé luminescent émet dans la zone délimitée par les coordonnées colorimétriques (x, y) suivantes :
| | | | | | | | |
|---|---|---|---|---|---|---|---|
| x | 0.3231 | 0.2702 | 0.2000 | 0.2550 | 0.3600 | 0.4087 | 0.3231 |
| y | 0.6722 | 0.6158 | 0.3950 | 0.3650 | 0.5300 | 0.5896 | 0.6722 |

3. Article selon l'une des revendications 1 ou 2, **caractérisé en ce que** le composé luminescent émet dans la zone délimitée par les coordonnées colorimétriques (x, y) suivantes :
| | | | | | | | |
|---|---|---|---|---|---|---|---|
| x | 0.3231 | 0.2702 | 0.2000 | 0.2550 | 0.3451 | 0.3980 | 0.3231 |
| y | 0.6722 | 0.6158 | 0.3950 | 0.3650 | 0.5437 | 0.6001 | 0.6722 |

4. Article selon l'une des revendications 1 à 3, **caractérisé en ce que** le composé luminescent présente un pic d'émission à une longueur d'onde comprise entre 500 et 575 nm et de largeur à mi-hauteur comprise entre 50 et 145 nm.

5. Article selon l'une des revendications 1 à 4, **caractérisé en ce que** le composé luminescent est choisi de sorte que l'ensemble source/milieu luminescent émette dans la zone délimitée par les coordonnées colorimétriques (x, y) suivantes :
| | | | | | | | | | |
|---|---|---|---|---|---|---|---|---|---|
| x | 0.305 | 0.180 | 0.180 | 0.200 | 0.235 | 0.265 | 0.330 | 0.385 | 0.305 |
| y | 0.485 | 0.310 | 0.280 | 0.265 | 0.330 | 0.315 | 0.380 | 0.425 | 0.485 |

6. Article selon l'une des revendications 1 à 5, **caractérisé en ce que** le composé luminescent est choisi de sorte que l'ensemble source/milieu luminescent émette dans la zone délimitée par les coordonnées colorimétriques (x, y) suivantes :
| | | | | | | | |
|---|---|---|---|---|---|---|---|
| x | 0.260 | 0.180 | 0.200 | 0.235 | 0.265 | 0.330 | 0.260 |
| y | 0.420 | 0.280 | 0.265 | 0.330 | 0.315 | 0.380 | 0.420 |

7. Article selon l'une des revendications 1 à 6 **caractérisé en ce que** le composé luminescent est choisi en fonction de la vitrocéramique et de la source lumineuse de façon à former au moins une zone lumineuse de couleur blanche en au moins une zone de la plaque, en particulier de couleur blanche de coordonnées colorimétriques (x, y) suivantes:
| | | | | | | | | | |
|---|---|---|---|---|---|---|---|---|---|
| x | 0.4791 | 0.3983 | 0.3382 | 0.2668 | 0.2810 | 0.3523 | 0.4124 | 0.4932 | 0.4791 |
| y | 0.4217 | 0.3979 | 0.3590 | 0.2877 | 0.2735 | 0.3449 | 0.3838 | 0.4076 | 0.4217 |

8. Article selon l'une des revendications 1 à 7, **caractérisé en ce que** le composé luminescent est choisi en fonction de la vitrocéramique et de la source lumineuse de façon à former au moins une zone lumineuse de couleur blanche de coordonnées colorimétriques (x, y) suivantes :
| | | | | | | | |
|---|---|---|---|---|---|---|---|
| x | 0.4039 | 0.3381 | 0.2801 | 0.2942 | 0.3523 | 0.4181 | 0.4039 |
| y | 0.4005 | 0.3589 | 0.3032 | 0.2891 | 0.3448 | 0.3864 | 0.4005 |

9. Article selon l'une des revendications 1 à 8, **caractérisé en ce que** le composé luminescent est choisi en fonction de la vitrocéramique et de la source lumineuse de façon à former au moins une zone lumineuse de couleur blanche de coordonnées colorimétriques (x, y) suivantes :
| | | | | | | | |
|---|---|---|---|---|---|---|---|
| x | 0.3409 | 0.3001 | 0.2800 | 0.2942 | 0.3142 | 0.3550 | 0.3409 |
| y | 0.3609 | 0.3245 | 0.3031 | 0.2889 | 0.3104 | 0.3468 | 0.3609 |

10. Article selon l'une des revendications 1 à 9, **caractérisé en ce que** le substrat vitrocéramique comprend les constituants suivants et/ou est obtenu par céramisation à partir d'un verre de composition suivante : SiO₂: 52 - 75 %; Al₂O₃: 18 - 27 %; Li₂O: 2,5 - 5,5 %; K₂O : 0 - 3 %; Na₂O : 0 - 3 %; :ZnO : 0 - 3,5 %; MgO : 0 - 3 %; CaO: 0 - 2,5%; BaO : 0 - 3,5 %; SrO : 0 - 2 %; TiO₂ : 1,2 - 5,5 %; ZrO₂ : 0-3 %; P₂O₅ : 0 - 8 %.

11. Article selon l'une des revendications 1 à 10, **caractérisé en ce que** le substrat vitrocéramique comprend moins de 0,2%, en particulier moins de 0,15%, d'agents colorants, Fe₂O₃,V₂O₅ et CoO étant les colorants préférentiellement utilisés.

12. Article selon l'une des revendications 1 à 11, **caractérisé en ce que** le substrat vitrocéramique comprend un ou des agents colorants suivants dans les limites suivantes : V₂O₅ : 0,005% - 0,2% ; Fe₂O₃ : 0 - 0,2 %; CoO : 0 - 1 %; NiO: 0 - 0,005%; CuO : 0 - 0,005%; MnO : 0 - 0,05%; Rb₂O : 0 - 0,1%; As₂O₃ + Sb₂O₃, : 0 - 0,1% ; Cr₂O₃ : 0 - 0,0015%, le substrat vitrocéramique étant en outre préférentiellement dénué de P₂O₅, B₂O₃ et F.

13. Article selon l'une des revendications 1 à 12, **caractérisé en ce que** le milieu luminescent, formé par le composé luminescent et la matrice éventuelle l'incorporant, présente une absorbance A_{λ} supérieure à 0.274, et de préférence supérieure à 0.297 à la longueur d'onde d'émission de la source lumineuse.

14. Article selon l'une des revendications 1 à 13, **caractérisé en ce que** la zone lumineuse présente une valeur de luminance supérieure à 10 candela/m², en particulier supérieure à 20 candela/m², et notamment supérieure à 50, voire 70 candela/m².

15. Article selon l'une des revendications 1 à 14, **caractérisé en ce que** le composé luminescent est incorporé dans un liant silicone ou acrylate.

16. Article selon l'une des revendications 1 à 15, en particulier dispositif de cuisson et/ou de maintien à haute température, ledit article comportant en outre un ou plusieurs éléments de chauffage.

## Patentansprüche

1. Artikel, welcher mindestens eine Zone, insbesondere eine Lichtanzeigezone, insbesondere weiß, aufweist, wobei der Artikel umfasst: mindestens ein Glaskeramiksubstrat mit einer Lichtdurchlässigkeit von 0,8 % bis 40 % und einer optischen Durchlässigkeit von mindestens 0,1 % für mindestens eine Wellenlänge im Bereich von 420 bis 780 nm, mindestens eine Lichtquelle, insbesondere eine Elektrolumineszenzdiode, mit einem Emissionspeak bei einer Wellenlänge zwischen 430 und 490 nm, und mindestens eine emittierende Lumineszenzverbindung in der Zone, die von den folgenden kolorimetrischen Koordinaten (x, y) begrenzt wird:
| | | | | | |
|---|---|---|---|---|---|
| x | 0,2658 | 0,2000 | 0,3000 | 0,4229 | 0,2658 |
| y | 0,7243 | 0,3950 | 0,3405 | 0,5756 | 0,7243 |
um mindestens eine Zone, insbesondere eine Leuchtanzeigezone, insbesondere weiß, in mindestens einer Zone der Platte zu bilden, wobei die Lumineszenzverbindung außerdem derart ausgewählt ist, sodass die Zusammenstellung Quelle/ Lumineszenzverbindung in dem durch die folgenden kolorimetrischen Koordinaten (x, y) begrenzten Gebiet emittiert:
| | | | | | | | | | |
|---|---|---|---|---|---|---|---|---|---|
| x | 0,460 | 0,385 | 0,255 | 0,190 | 0,175 | 0,180 | 0,305 | 0,385 | 0,460 |
| y | 0,440 | 0,425 | 0,305 | 0,255 | 0,270 | 0,310 | 0,485 | 0,510 | 0,440 |

2. Artikel nach Anspruch 1,
**dadurch gekennzeichnet, dass** die Lumineszenzverbindung in der Zone emittiert, die von den folgenden kolorimetrischen Koordinaten (x, y) begrenzt wird:
| | | | | | | | |
|---|---|---|---|---|---|---|---|
| x | 0,3231 | 0,2702 | 0,2000 | 0,2550 | 0,3600 | 0,4087 | 0,3231 |
| y | 0,6722 | 0,6158 | 0,3950 | 0,3650 | 0,5300 | 0,5896 | 0,6722 |

3. Artikel nach einem der Ansprüche 1 oder 2,
**dadurch gekennzeichnet, dass** die Lumineszenzverbindung in der Zone emittiert, die von den folgenden kolorimetrischen Koordinaten (x, y) begrenzt wird:
| | | | | | | | |
|---|---|---|---|---|---|---|---|
| x | 0,3231 | 0,2702 | 0,2000 | 0,2550 | 0,3451 | 0,3980 | 0,3231 |
| y | 0,6722 | 0,6158 | 0,3950 | 0,3650 | 0,5437 | 0,6001 | 0,6722 |

4. Artikel nach einem der Ansprüche 1 bis 3,
**dadurch gekennzeichnet, dass** die Lumineszenzverbindung einen Emissionspeak bei einer Wellenlänge zwischen 500 und 575 nm und mit einer Breite auf halber Höhe zwischen 50 und 145 nm aufweist.

5. Artikel nach einem der Ansprüche 1 bis 4,
**dadurch gekennzeichnet, dass** die Lumineszenzverbindung derart ausgewählt ist, sodass die Zusammenstellung Quelle/ Lumineszenzverbindung in dem durch die folgenden kolorimetrischen Koordinaten (x, y) begrenzten Gebiet emittiert:
| | | | | | | | | | |
|---|---|---|---|---|---|---|---|---|---|
| x | 0,305 | 0,180 | 0,180 | 0,200 | 0,235 | 0,265 | 0,330 | 0,385 | 0,305 |
| y | 0,485 | 0,310 | 0,280 | 0,265 | 0,330 | 0,315 | 0,380 | 0,425 | 0,485 |

6. Artikel nach einem der Ansprüche 1 bis 5,
**dadurch gekennzeichnet, dass** die Lumineszenzverbindung derart ausgewählt ist, sodass die Zusammenstellung Quelle/ Lumineszenzverbindung in dem durch die folgenden kolorimetrischen Koordinaten (x, y) begrenzten Gebiet emittiert:
| | | | | | | | |
|---|---|---|---|---|---|---|---|
| x | 0,260 | 0,180 | 0,200 | 0,235 | 0,265 | 0,330 | 0,260 |
| y | 0,420 | 0,280 | 0,265 | 0,330 | 0,315 | 0,380 | 0,420 |

7. Artikel nach einem der Ansprüche 1 bis 6,
**dadurch gekennzeichnet, dass** die Lumineszenzverbindung als Funktion der Glaskeramik und der Lichtquelle ausgewählt ist, um mindestens eine Lichtzone mit weißer Farbe in mindestens einer Zone der Platte zu bilden, insbesondere mit weißer Farbe mit folgenden kolorimetrischen Koordinaten (x, y):
| | | | | | | | | | |
|---|---|---|---|---|---|---|---|---|---|
| x | 0,4791 | 0,3983 | 0,3382 | 0,2668 | 0,2810 | 0,3523 | 0,4124 | 0,4932 | 0,4791 |
| y | 0,4217 | 0,3979 | 0,3590 | 0,2877 | 0,2735 | 0,3449 | 0,3838 | 0,4076 | 0,4217 |

8. Artikel nach einem der Ansprüche 1 bis 7,
**dadurch gekennzeichnet, dass** die Lumineszenzverbindung als Funktion der Glaskeramik und der Lichtquelle ausgewählt ist, um mindestens eine Lichtzone mit weißer Farbe mit folgenden kolorimetrischen Koordinaten (x, y) zu bilden:
| | | | | | | | |
|---|---|---|---|---|---|---|---|
| x | 0,4039 | 0,3381 | 0,2801 | 0,2942 | 0,3523 | 0,4181 | 0,4039 |
| y | 0,4005 | 0,3589 | 0,3032 | 0,2891 | 0,3448 | 0,3864 | 0,4005 |

9. Artikel nach einem der Ansprüche 1 bis 8,
**dadurch gekennzeichnet, dass** die Lumineszenzverbindung als Funktion der Glaskeramik und der Lichtquelle ausgewählt ist, um mindestens eine Lichtzone mit weißer Farbe mit folgenden kolorimetrischen Koordinaten (x, y) zu bilden:
| | | | | | | | |
|---|---|---|---|---|---|---|---|
| x | 0,3409 | 0,3001 | 0,2800 | 0,2942 | 0,3142 | 0,3550 | 0,3409 |
| y | 0,3609 | 0,3245 | 0,3031 | 0,2889 | 0,3104 | 0,3468 | 0,3609 |

10. Artikel nach einem der Ansprüche 1 bis 9,
**dadurch gekennzeichnet, dass** das Glaskeramiksubstrat die folgenden Bestandteile umfasst und/oder durch Keramisierung aus einem Glas mit der folgenden Zusammensetzung erhalten wird: SiO₂: 52 - 75 %; Al₂O₃: 18 - 27 %; Li₂O: 2,5 - 5,5 %; K₂O: 0 - 3 %; Na₂O: 0 - 3 %; ZnO: 0 - 3,5 %; MgO: 0 - 3 %; CaO: 0 - 2,5 %; BaO: 0 - 3,5 %; SrO: 0 - 2 %; TiO₂: 1,2 - 5,5 %; ZrO₂: 0 - 3 %; P₂O₅: 0 - 8 %.

11. Artikel nach einem der Ansprüche 1 bis 10,
**dadurch gekennzeichnet, dass** das Glaskeramiksubstrat weniger als 0,2 %, insbesondere weniger als 0,15 %, Farbstoffe umfasst, wobei Fe₂O₃, V₂O₅ und CoO die bevorzugt verwendeten Farbstoffe sind.

12. Artikel nach einem der Ansprüche 1 bis 11,
**dadurch gekennzeichnet, dass** das Glaskeramiksubstrat einen Farbstoff oder folgende Farbstoffe innerhalb der folgenden Grenzen umfasst: V₂O₅: 0,005 % - 0,2 %; Fe₂O₃: 0 - 0,2 %; CoO: 0 - 1 %; NiO: 0 - 0,005 %; CuO: 0 - 0,005 %; MnO: 0 - 0,05 %; Rb₂O: 0 - 0,1 %; As₂O₃ + Sb₂O₃: 0 - 0,1 %; Cr₂O₃: 0 - 0,0015 %; wobei das Glaskeramiksubstrat außerdem vorzugsweise frei von P₂O₅, B₂O₃ und F ist.

13. Artikel nach einem der Ansprüche 1 bis 12,
**dadurch gekennzeichnet, dass** das Lumineszenzmedium, das von der Lumineszenzverbindung und der eventuellen Matrix, die diese einschließt, gebildet wird, ein Absorptionsvermögen A_{λ} von mehr als 0,274 und vorzugsweise mehr als 0,297 bei der Emissionswellenlänge der Lichtquelle aufweist.

14. Artikel nach einem der Ansprüche 1 bis 13,
**dadurch gekennzeichnet, dass** die Lichtzone einen Luminanzwert von mehr als 10 Candela/m², insbesondere mehr als 20 Candela/m², und insbesondere mehr als 50, sogar 70 Candela/m² aufweist.

15. Artikel nach einem der Ansprüche 1 bis 14,
**dadurch gekennzeichnet, dass** die Lumineszenzverbindung in einem Silikon- oder Acrylat-Bindemittel eingeschlossen ist.

16. Artikel nach einem der Ansprüche 1 bis 15,
insbesondere Vorrichtung zum Kochen und/oder zum Halten bei einer hohen Temperatur, wobei der Artikel außerdem ein oder mehrere Heizelemente umfasst.

## Claims

1. Article having at least one luminous, in particular white, area, in particular for display purposes said article comprising at least one glass-ceramic substrate having a light transmission from 0.8% to 40% and an optical transmission of at least 0.1% for at least a wavelength within the range from 420 to 780 nm, at least one light source, in particular a light-emitting diode, having an emission peak at a wavelength between 430 and 490 nm, and at least one luminescent compound emitting in the area delimited by the following colorimetric coordinates (x, y):
| | | | | | |
|---|---|---|---|---|---|
| x | 0.2658 | 0.2000 | 0.3000 | 0.4229 | 0.2658 |
| y | 0.7243 | 0.3950 | 0.3405 | 0.5756 | 0.7243 |
so as to form at least one luminous area, particularly white, in particular for display purposes, in at least one area of the plate, said luminescent compound being furthermore chosen so that the assembly source/luminescent compound emits in the area delimited by the following coordinates (x, y):
| | | | | | | | | | |
|---|---|---|---|---|---|---|---|---|---|
| x | 0.460 | 0.385 | 0.255 | 0.190 | 0.175 | 0.180 | 0.305 | 0.385 | 0.460 |
| y | 0.440 | 0.425 | 0.305 | 0.255 | 0.270 | 0.310 | 0.485 | 0.510 | 0.440 |

2. Article according to Claim 1, **characterized in that** the luminescent compound emits in the area delimited by the following colorimetric coordinates (x, y):
| | | | | | | | |
|---|---|---|---|---|---|---|---|
| x | 0.3231 | 0.2702 | 0.2000 | 0.2550 | 0.3600 | 0.4087 | 0.3231 |
| y | 0.6722 | 0.6158 | 0.3950 | 0.3650 | 0.5300 | 0.5896 | 0.6722 |

3. Article according to either of Claims 1 and 2, **characterized in that** the luminescent compound emits in the area delimited by the following colorimetric coordinates (x, y):
| | | | | | | | |
|---|---|---|---|---|---|---|---|
| x | 0.3231 | 0.2702 | 0.2000 | 0.2550 | 0.3451 | 0.3980 | 0.3231 |
| y | 0.6722 | 0.6158 | 0.3950 | 0.3650 | 0.5437 | 0.6001 | 0.6722 |

4. Article according to any of Claims 1 to 3, **characterized in that** the luminescent compound presents an emission peak at a wavelength between 500 and 575 nm and with a mid-height width between 50 and 145 nm.

5. Article according to any of Claims 1 to 4, **characterized in that** the luminescent compound is chosen so that the assembly source/luminescent compound emits in the area delimited by the following coordinates (x, y):
| | | | | | | | | | |
|---|---|---|---|---|---|---|---|---|---|
| x | 0.305 | 0.180 | 0.180 | 0.200 | 0.235 | 0.265 | 0.330 | 0.385 | 0.305 |
| y | 0.485 | 0.310 | 0.280 | 0.265 | 0.330 | 0.315 | 0.380 | 0.425 | 0.485 |

6. Article according to any of claims 1 to 5, **characterized in that** the luminescent compound is chosen so that the assembly source/luminescent compound emits in the area delimited by the following coordinates (x, y):
| | | | | | | | |
|---|---|---|---|---|---|---|---|
| x | 0.260 | 0.180 | 0.200 | 0.235 | 0.265 | 0.330 | 0.260 |
| y | 0.420 | 0.280 | 0.265 | 0.330 | 0.315 | 0.380 | 0.420 |

7. Article according to any of claims 1 to 6, **characterized in that** the luminescent compound is chosen as a function of the glass-ceramic and the light source so as to form at least one luminous area having a white color on at least one area of the plate, in particular a white color having the following colorimetric coordinates (x, y):
| | | | | | | | | | |
|---|---|---|---|---|---|---|---|---|---|
| x | 0.4791 | 0.3983 | 0.3382 | 0.2668 | 0.2810 | 0.3523 | 0.4124 | 0.4932 | 0.4791 |
| y | 0.4217 | 0.3979 | 0.3590 | 0.2877 | 0.2735 | 0.3449 | 0.3838 | 0.4076 | 0.4217 |

8. Article according to any of Claims 1 to 7, **characterized in that** the luminescent compound is chosen as a function of the glass-ceramic and the light source so as to form at least one luminous area having a white color with the following colorimetric coordinates (x, y):
| | | | | | | | |
|---|---|---|---|---|---|---|---|
| x | 0.4039 | 0.3381 | 0.2801 | 0.2942 | 0.3523 | 0.4181 | 0.4039 |
| y | 0.4005 | 0.3589 | 0.3032 | 0.2891 | 0.3448 | 0.3864 | 0.4005 |

9. Article according to any of Claims 1 to 8, **characterized in that** the luminescent compound is chosen as a function of the glass-ceramic and the light source so as to form at least one luminous area having a white color with the following colorimetric coordinates (x, y):
| | | | | | | | |
|---|---|---|---|---|---|---|---|
| x | 0.3409 | 0.3001 | 0.2800 | 0.2942 | 0.3142 | 0.3550 | 0.3409 |
| y | 0.3609 | 0.3245 | 0.3031 | 0.2889 | 0.3104 | 0.3468 | 0.3609 |

10. Article according to any of Claims 1 to 9, **characterized in that** the glass-ceramic substrate comprises the following components and/or is produced by ceramization from a glass having the following composition: SiO₂: 52 - 75%; Al₂O₃: 18 - 27%; Li₂O: 2.5 - 5.5%; K₂O: 0 - 3%; Na₂O: 0 - 3%; ZnO: 0 - 3.5%; MgO: 0 - 3%; CaO: 0 - 2.5%; BaO: 0 - 3.5%; SrO : 0 - 2%; TiO₂: 1.2 - 5.5%; ZrO₂: 0 - 3%; P₂O₅: 0 - 8%.

11. Article according to any of Claims 1 to 10, **characterized in that** the glass-ceramic substrate comprises less than 0.2%, particularly less than 0.15% of coloring agents, Fe₂O₃, V₂O₅ and CoO being the preferably used coloring agents.

12. Article according to any of Claims 1 to 11, **characterized in that** the glass-ceramic substrate comprises one or more of the following coloring agents within the following limits: V₂O₅: 0.005% - 0.2%; Fe₂O₃: 0 - 0.2%; CoO: 0 - 1%; NiO: 0 - 0.005%; CuO: 0 - 0.005%; MnO: 0 - 0.05%; Rb₂O: 0 - 0.1%; As₂O₃ + Sb₂O₃: 0 - 0.1%; Cr₂O₃: 0 - 0.0015%, the glass-ceramic substrate further being preferably free from P₂O₅, B₂O₃ and F.

13. Article according to any of Claims 1 to 12, **characterized in that** the luminescent medium, formed by the luminescent compound and any possible matrix incorporating it, has an absorbance A_{λ} greater than 0.274, and preferably greater than 0.297 at the emission wavelength of the light source.

14. Article according to any of Claims 1 to 13, **characterized in that** the luminous area has a luminance value of more than 10 candela/m², in particular more than 20 candela/m², and notably more than 50 or even 70 candela/m².

15. Article according to any of Claims 1 to 14, **characterized in that** the luminescent compound is incorporated in a silicone or acrylate binder.

16. Article according to any of Claims 1 to 15, particularly a cooking device and/or a device for maintaining at high temperature, said article further including one or more heating elements.
